Europäisches Patentamt

European Patent Office

Office européen des brevets

(19)

(11) **EP 0 491 422 B1**

(12) **EUROPÄISCHE PATENTSCHRIFT**

(45) Veröffentlichungstag und Bekanntmachung des Hinweises auf die Patenterteilung:
**13.03.1996 Patentblatt 1996/11**

(51) Int Cl.⁶: **H03H 17/06**

(21) Anmeldenummer: **91203221.6**

(22) Anmeldetag: **10.12.1991**

(54) **Schaltungsanordnung zur Taktumsetzung eines digitalen Signals**

Circuit arrangement for sampling rate conversion of a digital signal

Dispositif de conversion du taux d'échantillonage d'un signal numérique

(84) Benannte Vertragsstaaten:
**DE FR GB**

(30) Priorität: **17.12.1990 DE 4040299**

(43) Veröffentlichungstag der Anmeldung:
**24.06.1992 Patentblatt 1992/26**

(73) Patentinhaber:
 • **Philips Patentverwaltung GmbH**
   **D-22335 Hamburg (DE)**
   Benannte Vertragsstaaten:
   **DE**
 • **Philips Electronics N.V.**
   **NL-5621 BA Eindhoven (NL)**
   Benannte Vertragsstaaten:
   **FR GB**

(72) Erfinder: **Herrmann, Matthias**
   **W-3300 Braunschweig (DE)**

(74) Vertreter:
   **von Laue, Hanns-Ulrich, Dipl.-Ing. et al**
   **Philips Patentverwaltung GmbH,**
   **Röntgenstrasse 24**
   **D-22335 Hamburg (DE)**

(56) Entgegenhaltungen:
   **EP-A- 0 173 307      EP-A- 0 227 172**
   **EP-A- 0 285 413**

**Beschreibung**

Die Erfindung betrifft eine Schaltungsanordnung zur Umsetzung eines in einem ersten Takt vorliegenden digitalen Signals in einen zweiten Takt mit einem Interpolator/Dezimator, welcher eine vorgegebene Anzahl mit einem Registertakt getakteter und hintereinandergeschalter Eingangs-Register aufweist, deren Ausgangssignale mittels je eines Multiplizierers mit Filter-Koeffizienten multipliziert werden und die nachfolgend addiert werden.

Eine derartige Schaltungsanordnung ist beispielsweise aus der europäischen Patentanmeldung 0 336 669 bekannt. Diese Schaltungsanordnung arbeitet jedoch, wie viele andere derartige bekannte Anordnungen auch, mit einem bestimmten festen rationalen Zahlenverhältnis zwischen den Frequenzen des ersten und des zweiten Taktes. Es ist also eine wesentliche Einschränkung der Einsatzmöglichkeiten dieser Schaltungsanordnungen insofern gegeben, als das Frequenzverhältnis der beiden Taktsignale in einem bekannten, festen Verhältnis zueinander stehen muß. Der Grund, weshalb diese Einschränkung bei dieser bekannten Schaltungsanordnung zu machen ist, liegt darin, daß derartige Schaltungsanordnungen immer mit Registern arbeiten müssen, in denen die Daten zwischengespeichert werden. Ein Teil dieser Register muß dabei mit dem ersten Takt getaktet werden, ein anderer Teil mit dem zweiten Takt. Dabei ergibt sich das Problem, daß derartige Register nur in der Weise realisierbar sind, daß die Daten, die am Eingang eines Registers anliegen und in das Register übernommen werden sollen, sich während bestimmter Zeitintervalle nicht verändern dürfen. Es handelt sich dabei um die Zeitintervalle vor und nach derjenigen Taktflanke, mit der die Daten in das Register übernommen werden sollen. Außerdem stehen die Daten nach Übernahme in das Register erst mit einer zeitlichen Verzögerung am Ausgang an und sind erst nach dieser Zeitspanne gültig. Diese Zeiten werden üblicherweise mit "Data-setup- und Data-hold-Zeit" bezeichnet. Infolge dieser Zeiten, in denen die Eingangsdaten nicht verändert werden dürfen bzw. die Ausgangsdaten noch nicht gültig sind, gibt es bei Hintereinanderschaltung von Registern, die mit verschiedenen Taktsignalen getaktet werden, das Problem, daß bei einem Übereinanderlaufen der Flanken der Taktsignale sich die Ausgangsdaten des ersten Registers gerade dann ändern, wenn die Eingangssignale des zweiten Registers nicht verändert werden dürfen. Die in das zweite Register eingelesenen Daten sind dann undefiniert und stellen eine Störung des Signals dar.

Aus der europäischen Patentanmeldung 0 227 172 ist ein Koeffizientengenerator mit geschlossener Phasenregelschleife für ein Filter bekannt, das mit einem nicht rationalen Verhältnis zwischen der Eingangs- und der Ausgangsfrequenz arbeitet. Diese Anmeldung betrifft im wesentlichen das Problem der Generation der Filterkoeffizienten und behandelt die Anordnung zur Umsetzung des Taktes nur am Rade. Auch hier gilt, daß die beiden Taktsignale in einem festen Verhältnis zueinander stehen; sie können bei dem Gegenstand dieser Anmeldung jedoch auch in einem nicht rationalen Verhältnis zueinander stehen. Zum Ausgleich der beiden Taktfrequenzen ist am Eingang der Schaltungsanordnung ein Pufferspeicher vorgesehen.

Ferner ist aus EP-A-0 173 307 ein nicht rekursives Filter bekannt, welches mit bestimmten festen rationalen Zahlenverhältnissen zwischen den Frequenzen des ersten und des zweiten Taktes arbeitet. Diese Schaltungsanordnung weist zwei Eingangssignal-Pufferspeicher auf, deren Ausgänge durch eine Art Multiplexer zu der Filteranordnung verbunden werden.

Es ist Aufgabe der Erfindung, eine Schaltungsanordnung der eingangs genannten Art zu schaffen, welche einen einfachen Aufbau aufweist und eine Taktumsetzung zwischen zwei Taktsignalen gestattet, die nicht in einem festen Verhältnis zueinander stehen, die also asynchron sind und deren Taktflanken sich relativ zueinander verschieben und auch übereinander laufen, also gleichzeitig auftreten können.

Diese Aufgabe ist erfindungsgemäß dadurch gelöst, daß wenigstens eine Multiplexer-Anordnung vorgesehen ist, welche einem der hintereinandergeschalteten Eingangs-register nachgeschaltet und einem der Multiplizierer vorgeschaltet ist und welche eine mit dem invertierten ersten Takt getaktetes erstes und ein mit dem zweiten Takt getaktetes zweites Register sowie einen Multiplexer aufweist, daß das Eingangssignal der Multiplexer-Anordnung dem ersten Register und einem ersten Eingang des Multiplexers zugeführt wird, dessen zweiter Eingang mit dem Ausgang des ersten Registers gekoppelt ist, und daß eine Steuerung vorgesehen ist, welche die den beiden Eingängen des Multiplexers zugeführten Signale in der Weise wechselweise auf dessen Ausgang schaltet, daß an diesem immer zu den Zeitpunkten ein gültiges Signal vorhanden ist, zu denen dieses Signal in das zweite Register eingelesen wird.

Das eingangs beschriebene Problem, daß die Taktflanken der beiden gegebenenfalls asynchronen Takte sich freischwebend relativ zueinander verschieben und dabei durch ein mit dem zweiten Takt arbeitenden Register gerade dann ein neuer Wert des digitalen Signals übernommen werden soll, wenn sich das Siganl im ersten Abtasttakt gerade ändert, wenn also die Flanken der beiden Takte gerade übereinanderlaufen und gleichzeitig oder nahezu gleichzeitig auftreten, ist bei der erfindungsgemäßen Schaltungsanordnung dadurch beseitigt, daß wenigstens eine Multiplexeranordnung vorgesehen ist. Diese kann innerhalb der Schaltungsanordnung grundsätzlich an beliebiger geeigneter Stelle angeordnet sein. Ist sie beispielsweise innerhalb des Interpolators/Dezimators innerhalb dessen Polyphaserstruktur angeordnet, so ist in jedem Zweig des Interpolators/Dezimators eine Multiplexeranordnung vorzusehen.

In jeder Multiplexeranordnung ist ein Multiplexer mit zwei Eingängen vorgesehen. Dem ersten Eingang wird das in dem ersten Takt vorliegende digitale Signal zugeführt. Mit Hilfe des ersten Registers, das mit dem invertierten ersten Takt getaktet wird, gelangt an den zweiten Eingang des Multiplexers das gleiche digitale Signal, jedoch in der Phase um 180° verschoben. Diese beiden Eingänge können mittels einer Steuerung wahlweise auf den Ausgang des Multiplexers geschaltet werden, dessen Ausgangsdaten in ein zweites Register übernommen werden, das mit dem zweiten Takt arbeitet, also mit demjenigen Takt, in den das digitale Signal umgesetzt werden soll.

Wie oben beschrieben, dürfen einerseits die Eingangsdaten des zweiten Registers während des Zeitintervalls nicht geändert werden, in dem eine Taktflanke des zweiten Taktsignals auftritt, mit der neue Daten in das zweite Register übernommen werden. Darüber hinaus ändern sich die Eingangsdaten an beiden Eingängen des Multiplexers aber während derjenigen Zeiten, in denen die Ausgangsdaten vorgeschalteter Register sich verändern. Die Steuerung schaltet nun die beiden Eingänge des Multiplexers wechselweise so auf dessen Ausgang, daß am Ausgang des Multiplexers während derjenigen Zeitspannen, in denen in das zweite Register Signale eingelesen werden sollen, in denen sich also die an dem Eingang des zweiten Registers anliegenden Daten nicht verändern dürfen, feste gültige und sich nicht verändernde Daten anliegen. Es wird hierzu also zwischen dem in dem ersten Takt vorliegenden digitalen Signal und dem gleichen, um 180° bezüglich seiner Phase verschobenen Signal hin und hergeschaltet, so daß während derjenigen Zeitspannen, in denen in das zweite Register neue Daten übernommen werden, am Ausgang des Multiplexers immer dasjenige der beiden dem Multiplexer zugeführten Signale anliegt, das sich in dieser Zeitspanne mit Sicherheit nicht verändert.

Bei dieser Anordnung müssen der erste und der zweite Takt bezüglich ihres Frequenz-Verhältnisses nicht gekoppelt sein, können also asynchron sein und sich freischwebend zueinander verschieben. Damit ist die Schaltungsanordnung zur Taktumsetzung für sehr breite Anwendungsbereiche geeignet.

In einer Ausgestaltung der Erfindung ist vorgesehen, daß in dem Interpolator/Dezimator jedem der hintereinandergeschalteten Eingangs-Register je eine Multiplexer-Anordnung nachgeschaltet ist, deren Ausgangssignale dem jeweils zugeordneten Multiplizierer zugeführt werden, daß der erste Takt als Registertaktsignal eingesetzt wird und daß für die Multiplexer-Anordnungen eine gemeinsame Steuerung vorgesehen ist.

Interpolatoren/Dezimatoren weisen eine Struktur auf, welche eingangsseitig eine Registerkette vorsieht, wobei jedem der Register jeweils ein Multiplizierer nachgeschaltet ist, in dem die Ausgangsdaten des zugeordneten Registers mit einem Filterkoeffizienten beaufschlagt werden. Die so mit Filterkoeffizienten beaufschlagten Daten werden anschließend addiert. Die Multiplexer-anordnung kann nun vorteilhaft in jedem dieser Zweige des Interpolators/Dezimators vorgesehen sein.

Dazu ist sie in jedem Zweig des Interpolators/Dezimators zwischen das vorgeschaltete Register der hintereinanderandergeschalteten Register und den in dem Zweig vorgesehenen Multiplizierer zu schalten. In diesem Fall werden die hintereinandergeschalteten Eingangs-Register mit dem ersten Takt getaktet. Für alle in den verschiedenen Zweigen des Interpolators/Dezimators vorgesehenen Multiplexer-Anordnungen kann eine gemeinsame Steuerung vorgesehen sein, da in allen Zweigen die in den Multiplexer-Anordnungen vorgesehen Multiplexer in gleicher Weise umgeschaltet werden können. Dies ist möglich, da alle den Multiplexer-Anordnungen vorgeschalteten Eingangs-Register mit dem ersten Takt getaktet werden und sich also deren Ausgangssignale während gleicher Zeitintervalle ändern bzw. gültig sind.

Nach einer weiteren Ausgestaltung der Erfindung ist vorgesehen, daß in der Steuerung ein erstes und ein zweites Verzögerungsglied vorgesehen sind, welche das erste Taktsignal bzw. das invertierte erste Taktsignal um solche Werte zeitlich verzögern, daß die Flanken des verzögerten ersten Taktsignals diejenigen Zeitpunkte angeben, zu denen an den ersten Eingängen der Multiplizierer erscheinende neue Daten bereits gültig und an den zweiten Eingängen anliegende Daten noch gültig sind, und daß die Flanken des verzögerten invertierten ersten Taktsignals diejenigen Zeitpunkte angeben, zu denen an den zweiten Eingängen erscheinende neue Daten bereits gültig und an den ersten Eingängen anliegende Daten noch gültig sind.

Damit die Steuerung zwischen den Eingängen der Multiplexer in den Multiplexer-Anordnungen in der oben beschriebenen Weise umschalten kann, benötigt die Steuerung Informationen darüber, wann die Ausgangssignale der vorgeschalteten Register gültig sind und sich nicht verändern. Diese Informationen können in vorteilhafter Weise innerhalb der Steuerung dadurch gewonnen werden, daß das erste Taktsignal und das invertierte Taktsignal jeweils um solche Werte zeitlich verzögert werden, daß die Flanken dieser verzögerten Signale diejenigen Zeitpunkte angeben, zu denen an den Ausgängen der vorgeschalteten, mit dem ersten Takt oder mit dem invertierten ersten Takt der getakteten Register gültige Ausgangssignale erscheinen. Dabei wird das erste Taktsignal um einen solchen Wert verzögert, daß die Flanken dieses verzögerten Taktsignals diejenigen Zeitpunkte angeben, zu denen die an den ersten Eingängen der Multiplexer erscheinenden neuen Daten bereits gültig und gleichzeitig die an den zweiten Eingängen anliegenden Daten noch gültig sind. Die an den ersten Multiplexereingängen anliegenden Daten stammen von dem vorgeschalteten Register der hintereinandergeschalteten Eingangs-Register, dessen Ausgangssignale erst nach einer gewissen sogenannten "propagation delay time" gültig sind. Andererseits müssen die an den zweiten Eingängen der Multiplexer anliegenden Daten, die von dem ersten Register der Multiplexer-Anordnung stammen, noch gültig sein, d.h. es dürfen noch nicht wieder neue Daten in dieses Register eingelesen werden. Die von dem verzögerten ersten Taktsignal markierten Zeitpunkte müssen also zwischen diesen beiden Zeitpunkten liegen. Entsprechendes gilt in umgekehrter Weise für das verzögerte invertierte erste Taktsignal, das so ausgelegt sein muß, daß seine Flanken diejenigen Zeitpunkte angeben, zu denen die an den zweiten Eingängen 12 anliegenden von dem ersten Register stammenden Daten schon gültig sind und zu denen außerdem die an dem ersten Registereingängen anliegenden Daten, die von dem zugeordneten vorgeschalteten Register der hintereinandergeschalteten Register stammen, noch gültig sind. Damit geben die Taktflanken dieser verzögerten Taktsignale Zeitpunkte an, zu denen das jeweils zugeordnete an dem ersten oder am zweiten Eingang des Multiplexers anliegende Signal gültige Werte aufweist und das jeweils andere Signal noch gültig ist.

Diese Information kann vorteilhafterweise, gemäß einer weiteren Ausgestaltung, in der Weise ausgewertet werden, daß in der Steuerung ein erster Phasenvergleicher, welcher einen Phasenvergleich zwischen dem von dem ersten Verzögerungsglied gelieferten Taktsignal und dem zweiten Taktsignal vornimmt und ein zweiter Phasenvergleicher vorgesehen sind, welcher einen Phasenvergleich zwischen dem von dem zweiten Verzögerungsglied gelieferten Signal und dem zweiten Taktsignal vornimmt, daß die Ausgangssignale der beiden Phasenvergleicher auf einen ersten und einen zweiten Impulsgenerator geführt sind, und daß die Ausgangssignale der beiden Impulsgeneratoren zur Umschaltung der Multiplexer in den Multiplexer-Anordnungen herangezogen werden.

Wie oben beschrieben, muß verhindert werden, daß in das zweite Register gerade dann Daten übernommen werden sollen, wenn sich die Ausgangsdaten des Multiplexers bzw. der diesem vorgeschalteten Register gerade ändern. Dazu liefern die beiden Phasenvergleicher ein Signal, das die Phasenverschiebung zwischen dem von dem ersten Verzögerungsglied gelieferten Takt bzw. dem verzögerten invertierten ersten Takt und dem zweiten Takt angibt. Aus dieser Phasenverschiebung kann indirekt darauf geschlossen werden, wann die Flanken der ersten und zweiten Takte übereinanderlaufen und wann die oben beschriebene zu vermeidende Situation eintritt. Die Ausgangssignale der Phasenvergleicher bzw. der ihnen nachgeschalteten Impulsgeneratoren können daher dazu herangezogen werden, in gewünschter Weise zwischen den Multiplexer-Eingängen umzuschalten.

Dies kann vorteilhaft gemäß einer weiteren Ausgestaltung der Erfindung in der Weise geschehen, daß die Steuerung in Abhängigkeit der Ausgangssignale der beiden Impulsgeneratoren eine Umschaltung zwischen den beiden Multiplexereingängen der in den Multiplexer-Anordnungen vorgesehenen Multiplexer in der Weise vornimmt, daß auf die ersten Multiplexer-Eingänge umgeschaltet wird, wenn der erste Phasenkomparator ein Ausgangssignal liefert, das indiziert, daß die korrespondierenden Flanken des verzögerten ersten Taktsignals und des zweiten Taktsignals übereinander laufen, und daß auf die zweiten Multiplexer-Eingänge umgeschaltet wird, wenn der zweite Phasenkomparator ein Ausgangssignal liefert, das indiziert, daß die korrespondierenden Flanken des verzögerten invertierten ersten Taktsignals und des zweiten Taktsignals übereinander laufen.

Wenn das Ausgangssignal des ersten Phasenvergleichers bzw. des ihm nachgeschalteten ersten Impulsgenerators signalisiert, daß die Phasenverschiebung der Flanken des verzögerten ersten Taktsignals und des zweiten Taktsignals nahezu Null beträgt, bedeutet dies, daß zu denjenigen Zeitpunkten, in denen mit dem zweiten Taktsignal in das zweite Register Daten übernommen werden, die am ersten Eingang des Multiplexers anliegenden Daten gültig sind. Aus diesem Grunde nimmt die Steuerung in diesem Falle eine Umschaltung auf die ersten Multiplexer-Eingänge vor. Umgekehrt liefert der zweite Phasenkomparator bzw. der ihm nachgeschaltete Impulsgenerator dann ein Ausgangssignal, das eine Phase nahezu Null signalisiert, wenn die an den zweiten Eingängen der Multiplexer anliegenden Daten zu den Zeitpunkten gültig sind, zu denen das zweite Register mit dem zweiten Takt getaktet wird. In diesem Falle kann also durch die Steuerung auf die zweiten Multiplexer-Eingänge umgeschaltet werden. Diese relativ einfache Anordnung gestattet somit ein Umschalten zwischen den Multiplexer-Eingängen in der oben beschriebenen Weise.

Die Schaltungsanordnung kann insbesondere für ein digitales Fernsehsignal vorgesehen sein, das von einem ersten Takt in einen zweiten Takt umgesetzt werden soll. In diesem Zusammenhang kann insbesondere, gemäß einer weiteren Ausgestaltung der Erfindung vorgesehen sein, daß die Schaltungsanordnung zur Umsetzung eines in einem ersten Takt vorliegenden digitalen Signals in einen zweiten Takt einer Bildsignal-Verarbeitungsschaltung nachgeschaltet ist, in welcher ein digitales Bildsignal in einem nicht mit dem Bildsignal verkoppelten Systemtakt verarbeitet wird und in welcher ein Korrekturspeicher und ein Interpolator mit Dezimator vorgesehen sind, die der Konvertierung des digitalen Bildsignals auf ein durch den Systemtakt vorgegebenes Synchronsignalraster dienen, und daß die Schaltungsanordnung zur Umsetzung des digitalen Signals dazu herangezogen wird, daß von der Bildsignal-Verarbeitungsschaltung in dem Systemtakt gelieferte Bildsignal auf einen anderen Takt umzusetzen.

In der vorgeschalteten Bildsignal-Verarbeitungsschaltung wird dabei ein zuvor in einem freilaufenden, starren Takt abgetastetes und in den digitalen Bereich umgesetztes Fernsehsignal in den Korrekturspeicher eingelesen, dessen Ausgangssignale den in der Bildsignal-Verarbeitungsschaltung vorgesehenen Interpolator/Dezimator, der mit nur einem Takt arbeitet, durchlaufen. Die Aufgabe des Korrekturspeichers und des in der Bildsignal-Verarbeitungsschaltung vorgesehenen Interpolators/Dezimators besteht darin, die aufgrund der freilaufenden Abtastung zunächst asynchronen und möglicherweise bezüglich ihrer Zeitbasis instabilen Komponenten in ein definiertes starres, räumlich und zeitlich orthogonales Abtastraster zu transformieren. Am Ausgang dieser Bildsignal-Verarbeitungsschaltung liegen damit digitale Fernsehsignaldaten an, die in das orthogonale Raster transformiert sind. Es kann nun gegebenenfalls der Wunsch bestehen, diese Daten wiederum in einen anderen Abtasttakt umzusetzen, wozu die erfindungsgemäße Schaltungsanordnung vorteilhaft einsetzbar ist.

Nachfolgend wird anhand der Zeichnung ein Ausführungsbeispiel der Erfindung näher erläutert. Es zeigen:

Fig. 1 ein Blockschaltbild einer Ausführungsform der Schaltungsanordnung zur Taktumsetzung,

Fig. 2 einige zeitliche Signalverläufe der Schaltungsanordnung gemäß Fig. 1.

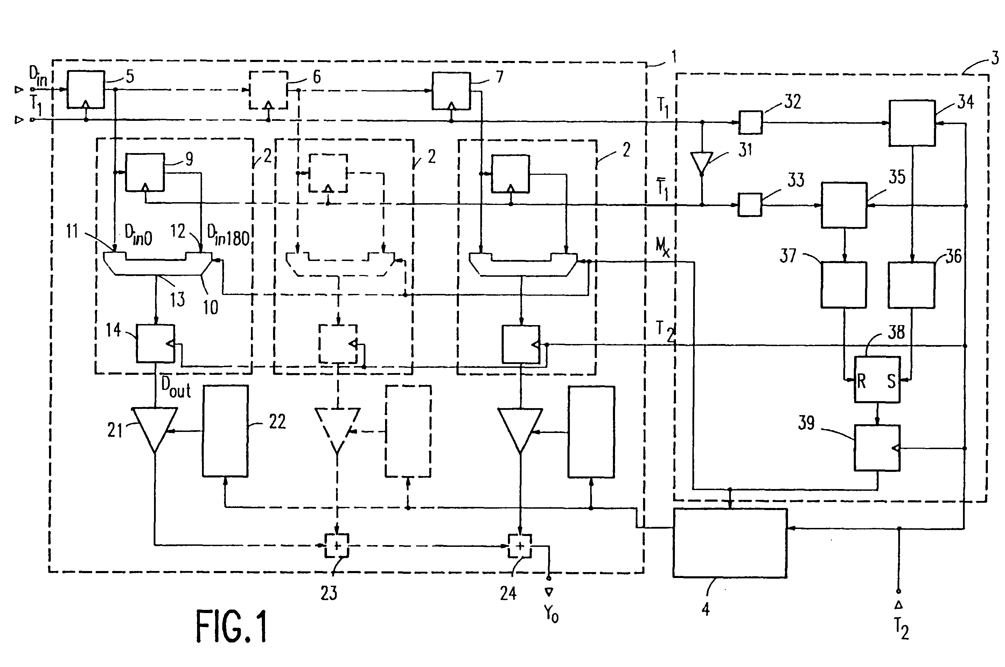

Das in Fig. 1 dargestellte Blockschaltbild einer Ausführungsform der erfindungsgemäßen Schaltungsanordnung zur Taktumsetzung eines digitalen Signals kann beispielsweise dazu dienen, ein in einem ersten Takt $T_1$ vorliegendes digitales Fernsehsignal, das in der Fig. mit $D_{in}$ bezeichnet ist, in einen zweiten Takt $T_2$ umzusetzen. Dazu weist die Schaltungsanordnung einen Interpolator/Dezimator 1 auf, in den mehrere Multiplexer-Anordnungen 2 integriert sind. Ferner ist eine Steuerung 3 vorgesehen, welche in den Multiplexer-Anordnungen 2 vorgesehene Multiplexer 10 steuert. Die Wahl der in dem Interpolator/Dezimator benötigten Filter-Koeffizienten wird durch eine Interpolator-Steuerung 4 vorgenommen.

Der in der Fig. 1 dargestellte Interpolator/Dezimator 1 weist in bekannter Weise eine polyphase Struktur auf. Auf die genaue Funktionsweise des Interpolators/Dezimators soll im folgenden nicht näher eingegangen werden; entsprechendes gilt für die Art der Auswahl der Filter-Koeffizienten in dem Interpolator/Dezimator durch die Steuerung 4.

Der Interpolator/Dezimator 1 weist eingangsseitig eine Reihe hintereinander geschalteter Eingangs-Register 5, 6 und 7 auf. Wieviele derartiger, hintereinandergeschalteter Register vorgesehen sind, hängt davon ab, wieviele Signale in dem Interpolator/Dezimator parallel in dessen Zweigen verarbeitet werden sollen. Die Wahl der Zahl der Zweige hängt wiederum davon ab, welche Restwelligkeit des Amplitudenfrequenzgangs die den Interpolator/Dezimator verlassenden Daten noch haben dürfen. Die Kriterien für die Auswahl dieser Parameter sind bekannt und werden im folgenden nicht näher beschrieben. Bei der Darstellung gemäß Fig. 1 wurde der Einfachheit halber davon ausgegangen, daß der Interpolator/Dezimator drei parallel geschaltete Zweige aufweist.

Die hintereinandergeschalteten Eingangs-Register 5, 6 und 7 werden in dem ersten Takt $T_1$ getaktet, in dem das digitale Fernsehsignal $D_{in}$ vorliegt. Somit wird also beispielsweise durch das Register 6 das am Ausgang des Registers 5 erscheinende Fernsehsignal um einen weiteren Abtasttakt verzögert. Das am Ausgang des Registers 6 erscheinende Signal wird durch das Register wiederum um einen weiteren Abtasttakt verzögert. Somit liegen also an den Ausgängen der Eingangs-Register 5, 6 und 7 um jeweils relativ zueinander einen Abtasttakt verschobene Daten des digitalen Fernsehsignals an.

Jedem der hintereinandergeschalteten Eingangs-Register 5, 6 und 7 ist je eine Multiplexer-Anordnung 2 nachgeschaltet. Die Multiplexer-Anordnungen 2 sind in gleicher Weise aufgebaut, so daß der im folgenden exemplarisch erörterte Aufbau der dem Eingangs-Register 5 nachgeschalteten Multiplexer-Anordnung mit ihren Bezugszeichen auf die den Eingangs-Registern 6 und 7 nachgeschalteten Multiplexer-Anordnungen ohne Änderung übertragbar ist. Jede der Multiplexer-Anordnungen 2 weist einen Multiplexer 10 auf, dessen erstem Eingang das Ausgangssignal des jeweils vorgeschalteten Registers der Reihe der hintereinandergeschalteten Register zugeführt wird.

In der dem Eingangs-Register 5 nachgeschalteten Multiplexer-Anordnung 2 weist der Multiplexer 10 einen ersten Eingang 11 auf, der mit dem Ausgang des Eingangs-Registers 5 verbunden ist. In ein in der Multiplexer-Anordnung 2 ferner vorgesehenes erstes Registers 9 werden ebenfalls die am Ausgang des Eingangs-Registers 5 erscheinenden Daten eingelesen. Dieses erste Register 9 wird mit dem invertierten ersten Takt, der in der Fig. 1 mit $\overline{T}_1$ bezeichnet ist, getaktet. Die Ausgangssignale des Registers 9 werden einem zweiten Eingang 12 des Registers 10 zugeführt. Infolge der Taktung des Registers 9 mit dem invertierten ersten Takt sind diese, am zweiten Eingang 12 des Registers 10 erscheinenden Daten gegenüber den am ersten Eingang 11 anliegenden Daten bezüglich ihrer Phase um 180° verschoben.

Der Multiplexer 10 weist einen Ausgang 13 auf, dessen Signale in ein nachgeschaltetes zweites Register 14 eingelesen werden. Dieses Register 14 ist mit dem zweiten Takt $T_2$ getaktet, in den die Daten umgesetzt werden sollen. Das Ausgangssignal $D_{out}$ des zweiten Registers 14 gelangt auf einen Multiplizierer 21, dem von einem Koeffizientenspeicher 22 Filter-Koeffizienten zugeführt werden, mit denen die digitalen Fernsehsignaldaten $D_{out}$ multipliziert werden.

Wie bereits erwähnt, sind mehrere in identischer Weise verschaltete Zweige des Interpolators/Dezimators mit jeweils einer Multiplexer-Anordnung 2, einem Multiplizierer 21 und einem Koeffizientenspeicher 22 in identischer Weise aufgebaut und parallel geschaltet. Die Ausgangssignale der Multiplizierer 21 der verschiedenen Zweige des Interpolators/Dezimators werden in Addierern 23 und 24 addiert, so daß am Ausgang des letzten Addierers 24 das gefilterte und vom ersten Takt in den zweiten Takt umgesetzte digitale Fernsehsignal anliegt, das in der Fig. 1 mit $Y_0$ bezeichnet ist.

Die Auswahl der in den verschiedenen Koeffizientenspeichern 22 abgespeicherten Filter-Koeffizienten wird durch die Interpolator-Steuerung 4 vorgenommen.

Die Steuerung der Multiplexer 10 in den Multiplexer-Anordnungen 2 wird mittels der Steuerung 3 vorgenommen. Dieser Steuerung wird das erste Taktsignal $T_1$ und das zweite Taktsignal $T_2$ zugeführt. In der Steuerung 3 wird mittels eines Inverters 31 eine Invertierung des ersten Taktsignals $T_1$ vorgenommen und so das invertierte erste Taktsignal $\bar{T}_1$ erzeugt. Dieses Taktsignal ist allen ersten Registern 9 innerhalb der Multiplexer-Anordnungen 2 zugeführt.

In der Steuerung 3 ist ferner ein erstes Verzögerungsglied 32 vorgesehen, daß das erste Taktsignal $T_1$ um einen solchen Wert verzögert, daß die Flanken des Ausgangssignals des ersten Verzögerungsgliedes 32 diejenigen Zeitpunkte angeben, zu denen die Ausgangssignale der Eingangs-Register 5, 6 und 7 gültige Werte aufweisen und zu denen die Ausgangsdaten der ersten Register 9 noch gültig sind. In entsprechender Weise ist ein zweites Verzögerungsglied 33 vorgesehen, das den invertierten ersten Takt $\bar{T}_1$ um einen solchen Wert verzögert, daß die Flanken seines Ausgangssignals diejenigen Zeitpunkte angeben, zu denen an den Ausgängen der ersten Register 9 der Multiplexer-Anordnungen 2 gültige Ausgangssignale vorhanden sind und zu denen die Ausgangsdaten der hintereinandergeschalteten Eingangs-Register 5, 6 und 7 noch gültig sind.

In der Steuerung 3 ist ferner ein erster Phasenvergleicher 34 vorgesehen, dem das Ausgangssignal des ersten Verzögerungsgliedes 32 sowie das zweite Taktsignal $T_2$ zugeführt sind. Einem zweiten Phasenvergleicher 35 ist das Ausgangssignal des Verzögerungsgliedes 33, also das Taktsignal $\bar{T}_{1\tau}$ sowie das zweite Taktsignal $T_2$ zugeführt. Dem ersten Phasenvergleicher 34 ist ein erster Impulsgenerator 36 und dem zweiten Phasenvergleicher 35 ein zweiter Impulsgenerator 37 nachgeschaltet. Die Ausgänge der Impulsgeneratoren 36 und 37 sind auf die beiden Eingänge eines statischen RS-Speichers 38 geführt. Das Ausgangssignal des Speichers 38 ist auf ein Register 39 geführt, das mit dem Takt $T_2$ getaktet wird. Das Ausgangssignal dieses Registers 39 stellt ein Schaltsignal $M_x$ dar, das allen Multiplexern 10 der Multiplexer-Anordnungen 2 zugeführt wird und daß der Umschaltung zwischen den beiden Eingängen dieser Multiplexer dient.

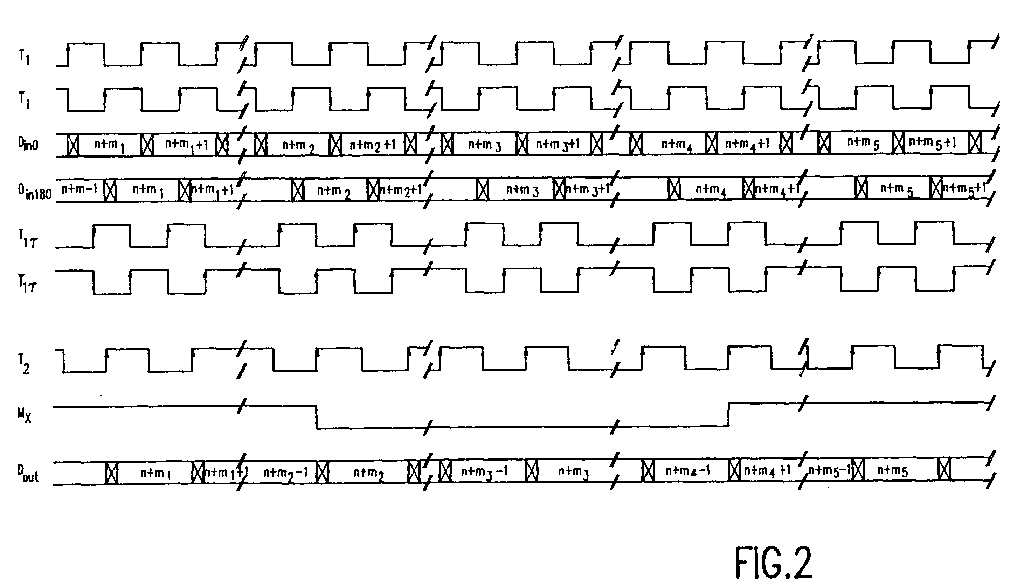

Im folgenden wird anhand der Fig. 2 und einiger in ihr dargestellter, über der Zeit aufgetragener Signalverläufe der Schaltung gemäß Fig. 1 die Arbeitsweise dieser Schaltung und insbesondere der Steuerung 3 und der Multiplexer-Anordnungen 2 näher erläutert.

Alle in der Fig. 2 bezüglich ihres zeitlichen Verlaufs dargestellten Signale sind mit zeitlichen Unterbrechungen, die durch Doppelstriche markiert sind, dargestellt, um bestimmte Zeitabschnitte, in denen eine Umschaltung zwischen den Multiplexer-Eingängen vorgenommen wird, herauszugreifen.

Das in der Fig. 2 dargestellte mit $T_1$ bezeichnete erste Taktsignal ist in der Schaltungsanordnung gemäß Fig. 1 den hintereinander geschalteten Eingangs-Registern 5, 6 und 7 zugeführt. Das in der Fig. 2 dargestellte und mit $\bar{T}_1$ bezeichnete invertierte erste Taktsignal ist in der Anordnung gemäß Fig. 1 den ersten Registern 9 aller Multiplexer-Anordnungen 2 zugeführt. Der in Fig. 2 mit $D_{in0}$ bezeichnete Signalverlauf zeigt die am ersten Eingang 11 der Multiplexer 10 anliegenden Daten, wie sie von dem vorgeschalteten Eingangs-Register 5, 6 oder 7 geliefert werden. Die in der Fig. 2 mit $D_{in180}$ bezeichneten Daten stellen diejenigen Daten dar, die von den ersten Registern 9 der jeweiligen Multiplexer-Anordnung 2 dem jeweiligen zweiten Eingang 12 des Multiplexers 10 zugeführt wird. In den Signalverläufen dieser beiden Signale sind in der Darstellung gemäß Fig. 2 mit einem Kreuz markierte Zeitbereiche angegeben, welche diejenigen Zeitbereiche darstellen, in denen sich die Ausgangsdaten der Register, aus denen die Daten $D_{in0}$ bzw. $D_{in180}$ stammen, ändern können.

Während dieser mit einem Kreuz markierten Zeiten liegen also an den Eingängen 11 bzw. 12 nicht gültige Daten an, die nicht auf den Ausgang 13 des jeweiligen Multiplexers 10 geschaltet werden sollten, da diese ungültigen Daten sich verändern und in das nachfolgende zweite Register 14 nicht fehlerfrei eingelesen werden könnten.

Um eben dieses zu verhindern, werden das erste Taktsignal $T_1$ und das invertierte erste Taktsignal $\bar{T}_1$ jeweils um einen Zeitwert $\tau$ verzögert. Diese verzögerten Taktsignale $T_{1\tau}$ und $\bar{T}_{1\tau}$ sind in der Fig. 2 ebenfalls dargestellt. Es wird deutlich, daß die ansteigenden Flanken dieser verzögerten Taktsignale in der Fig. 2 diejenigen Zeitpunkte angeben, zu denen die jeweils zugeordneten Daten nach einem ungültigen, mit einem Kreuz markierten Zeitabschnitt, gültig sind und zu denen die jeweils anderen Daten noch gültig sind. So weist in der Darstellung gemäß Fig. 2 das Signal $T_{1\tau}$ eine erste positive Flanke auf, nachdem die Daten $(n+m_1-1)$ des Signals $D_{in0}$ nach einem mit einem Kreuz markierten Bereich gültig sind. Zu diesem Zeitpunkt sind die am zweiten Eingang anliegenden Daten $(n + m_1)$ noch gültig.

In der Fig. 2 ist ferner der Signalverlauf des zweiten Taktsignales $T_2$ dargestellt. In der Steuerung 3 wird nun mittels der Phasenkomparatoren 34, 35 und der ihnen nachgeschalteten Impulsgeneratoren 36 und 37 ein Phasenvergleich vorgenommen, welcher angibt, wann die Flanken entweder des Signals $T_{1\tau}$ oder des Signals $\bar{T}_{1\tau}$ mit den korrespondierenden Flanken des zweiten Taktsignals $T_2$ gleichzeitig oder nahezu gleichzeitig auftreten bzw. übereinander laufen. In den zeitlichen Verläufen gemäß Fig. 2 ist dies erstmalig für das Signal $\bar{T}_{1\tau}$ und das Signal $T_2$ der Fall. Da das Signal $\bar{T}_{1\tau}$ angibt, wann die an den zweiten Eingängen 12 der Multiplexer 10 anliegenden Eingangssignale gültig sind, wird zu diesem Zeitpunkt das den Multiplexern 10 zur Umschaltung zwischen ihren Eingängen zugeführte Signal $M_x$ so generiert, daß die Multiplexer 10 auf diesen zweiten Eingang umschalten, an dem nunmehr gültige Daten anstehen. Wenn sich nachfolgend die Takte $T_1$ und $T_2$ und somit auch die Takte $T_{1\tau}$ und $\bar{T}_{1\tau}$ einerseits und $T_2$ an-

dererseits nur relativ wenig zueinander bewegen, bleiben die Multiplexer 10 weiterhin auf ihren zweiten Eingang geschaltet.

In der zeitlich gerafften Darstellung gemäß Fig. 2 tritt nach einiger Zeit der umgekehrte Fall ein, in dem nämlich die Signale $T_{1\tau}$ und $T_2$ gleiche oder annähernd gleiche Phasenlage erreichen. In diesem Falle werden die Multiplexer 10 mittels des Signals $M_x$, daß das Ausgangssignal des Registers 39 gemäß Fig. 1 darstellt, auf ihre ersten Eingänge 11 geschaltet. Dies kann nunmehr geschehen, da das Signal $T_{1\tau}$, das einen Zeitpunkt angibt, zu dem die an den ersten Eingängen 11 der Multiplexer 10 anliegenden Signal gültig sind und die an den zweiten Eingängen 12 anliegenden Daten noch gültig sind, mit dem Signal $T_2$ zusammenfällt, so daß mit der entsprechenden Flanke des Signales $T_2$ neue gültige Daten in das zweite Register 14 der jeweiligen Multiplexer-Anordnung 2 übernommen werden können.

Dieser Vorgang setzt sich nachfolgend (in der Fig. 2 nicht mehr dargestellt) fort, wobei jedesmal bei Koinzidenz des Signales $T_{1\tau}$ bzw. $\overline{T}_{1\tau}$ mit dem Signal $T_2$ auf den jeweils zugeordneten Multiplexer-Eingang 11 bzw. 12 umgeschaltet wird. Auf diese Weise ist auch bei asynchronen Taktsignalen $T_1$ und $T_2$, welche sich freischwebend zueinander verschieben können, jederzeit sichergestellt, daß nur zu solchen Zeitpunkten in die zweiten Register 14 der Multiplexer-Anordnungen 2 neue Daten eingelesen werden, zu denen an den Eingängen der zweiten Register 14 bzw. an den Ausgängen 13 der Multiplexer 10 gültige Daten zu Verfügung stehen. Diese Ausgangssignale der zweiten Register 14 sind in der Fig. 1 mit dem Signalverlauf $D_{out}$ bezeichnet. Diese Daten werden nachfolgend multipliziert und addiert und stellen das Ausgangssignal der Schaltungsanordnung dar.

**Patentansprüche**

1. Schaltungsanordnung zur Umsetzung eines in einem ersten Takt vorliegenden digitalen Signals in einen zweiten Takt mit einem Interpolator/Dezimator, welcher eine vorgegebene Anzahl mit einem Registertakt getakteter und hintereinandergeschalter Eingangs-Register (5, 6, 7) aufweist, deren Ausgangssignale mittels je eines Multiplizierers (21) mit Filter-Koeffizienten multipliziert werden und die nachfolgend addiert werden, dadurch gekennzeichnet, daß wenigstens eine Multiplexer-Anordnung (2) vorgesehen ist, welche einem der hintereinandergeschalteten Eingangsregister (5, 6, 7) nachgeschaltet und einem der Multiplizierer vorgeschaltet ist und welche eine mit dem invertierten ersten Takt getaktetes erstes (9) und ein mit dem zweiten Takt getaktetes zweites (14) Register sowie einen Multiplexer (10) aufweist, daß das Eingangssignal der Multiplexer-Anordnung (2) dem ersten Register (9) und einem ersten Eingang (11) des Multiplexers (10) zugeführt wird, dessen zweiter Eingang (12) mit dem Ausgang des ersten Registers (9) gekoppelt ist, und daß eine Steuerung (3) vorgesehen ist, welche die den beiden Eingängen (11, 12) des Multiplexers (10) zugeführten Signale in der Weise wechselweise auf dessen Ausgang schaltet, daß an diesem immer zu den Zeitpunkten ein gültiges Signal vorhanden ist, zu denen dieses Signal in das zweite Register (14) eingelesen wird.

2. Schaltungsanordnung nach Anspruch 1, dadurch gekennzeichnet, daß in dem Interpolator/Dezimator (1) jedem der hintereinandergeschalteten Eingangs-Register (5, 6, 7) je eine Multiplexer-Anordnung (2) nachgeschaltet ist, deren Ausgangssignale dem jeweils zugeordneten Multiplizierer (21) zugeführt werden, daß der erste Takt als Registertaktsignal eingesetzt wird und daß für die Multiplexer-Anordnungen (2) eine gemeinsame Steuerung (3) vorgesehen ist.

3. Schaltungsanordnung nach Anspruch 1 oder 2, dadurch gekennzeichnet, daß in der Steuerung (3) ein erstes (32) und ein zweites (33) Verzögerungsglied vorgesehen sind, welche das erste Taktsignal bzw. das invertierte erste Taktsignal um solche Werte zeitlich verzögern, daß die Flanken des verzögerten ersten Taktsignals diejenigen Zeitpunkte angeben, zu denen an den ersten Eingängen (11) der Multiplizierer (10) erscheinende neue Daten bereits gültig und an den zweiten Eingängen (12) anliegende Daten noch gültig sind, und daß die Flanken des verzögerten invertierten ersten Taktsignals diejenigen Zeitpunkte angeben, zu denen an den zweiten Eingängen (12) erscheinende neue Daten bereits gültig und an den ersten Eingängen (11) anliegende Daten noch gültig sind.

4. Schaltungsanordnung nach Anspruch 3, dadurch gekennzeichnet, daß in der Steuerung (3) ein erster Phasenvergleicher (34), welcher einen Phasenvergleich zwischen dem von dem ersten Verzögerungsglied gelieferten Taktsignal und dem zweiten Taktsignal vornimmt und ein zweiter Phasenvergleicher (35) vorgesehen sind, welcher einen Phasenvergleich zwischen dem von dem zweiten Verzögerungsglied gelieferten Signal und dem zweiten Taktsignal vornimmt, daß die Ausgangssignale der beiden Phasenvergleicher (34, 35) auf einen ersten (36) und einen zweiten (37) Impulsgenerator geführt sind, und daß die Ausgangssignale der beiden Impulsgeneratoren (36, 37) zur Umschaltung der Multiplexer (11) in den Multiplexer-Anordnungen (2) herangezogen werden.

5. Schaltungsanordnung nach Anspruch 4, dadurch gekennzeichnet, daß die Steuerung (3) in Abhängigkeit der Ausgangssignale der beiden Impulsgeneratoren (36, 37) eine Umschaltung zwischen den beiden Multiplexereingängen (11, 12) der in den Multiplexer-Anordnungen (2) vorgesehenen Multiplexer (10) in der Weise vornimmt, daß auf die ersten Multiplexer-Eingänge umgeschaltet wird, wenn der erste Phasenkomparator (34) ein Ausgangssignal liefert, das indiziert, daß die korrespondierenden Flanken des verzögerten ersten Taktsignals und des zweiten Taktsignals übereinander laufen, und daß auf die zweiten Multiplexer-Eingänge (12) umgeschaltet wird, wenn der zweite Phasenkomparator (35) ein Ausgangssignal liefert, das indiziert, daß die korrespondierenden Flanken des verzögerten invertierten ersten Taktsignals und des zweiten Taktsignals übereinander laufen.

6. Schaltungsanordnung nach einem der Ansprüche 1 bis 5,
dadurch gekennzeichnet, daß das digitale Signal ein digitales Fernsehsignal ist.

7. Schaltungsanordnung nach Anspruch 6,
dadurch gekennzeichnet, daß die Schaltungsanordnung zur Umsetzung eines in einem ersten Takt vorliegenden digitalen Signals in einen zweiten Takt einer Bildsignal-Verarbeitungsschaltung nachgeschaltet ist, in welcher ein digitales Bildsignal in einem nicht mit dem Bildsignal verkoppelten Systemtakt verarbeitet wird und in welcher ein Korrekturspeicher und ein Interpolator mit Dezimator vorgesehen sind, die der Konvertierung des digitalen Bildsignals auf einen durch den Systemtakt vorgegebenes Synchronsignalraster dienen, und daß die Schaltungsanordnung zur Umsetzung des digitalen Signals dazu herangezogen wird, daß von der Bildsignal-Verarbeitungsschaltung in dem Systemtakt gelieferte Bildsignal auf einen anderen Takt umzusetzten.

**Claims**

1. A circuit arrangement for converting of a digital signal having a first clock frequency into a signal having a second clock frequency, comprising an interpolator/decimator which includes a series of successively connected input registers (5, 6, 7) which are clocked at a register clock frequency and whose output signals are multiplied, by way of a respective multiplier (21), by filter coefficients and added subsequently, characterized in that at least one multiplexer arrangement (2) is provided which succeeds one of the successively connected input registers (5, 6, 7) and precedes one of the subsequent multipliers, which multiplexer arrangement comprises a first register (9) which is clocked at the inverted first clock frequency and a second register (14) which is clocked at the second clock frequency, and also comprises a multiplexer (10), that the input signal of the multiplexer arrangement (2) is applied to the first register (9) and to a first input (11) of the multiplexer (10) whose second input (12) is coupled to the output of the first register (9), and that there is provided a control circuit (3) which switches the signals applied to the two inputs (11, 12) of the multiplexer (10) to the output thereof in an alternating fashion so that a valid signal is present thereon at all instants at which this signal is written into the second register (14).

2. A circuit arrangement as claimed in Claim 1, characterized in that each of the successively connected input registers (5, 6, 7) in the interpolator/decimator (1) is succeeded by a respective multiplexer arrangement (2) whose output signals are applied to the respective associated multiplier (21), that the first clock frequency is used as the register clock signal, and that a common control circuit (3) is provided for the multiplexer arrangements (2).

3. A circuit arrangement as claimed in Claim 1 or 2, characterized in that the control circuit (3) comprises a first (32) and a second (33) delay member for delaying the first clock signal and the inverted first clock signal, respectively, by such an amount of time that the edges of the delayed first clock signal indicate the instants at which new data appearing at the first inputs (11) of the multipliers (10) is already valid and data present at the second inputs (12) is still valid, and that the edges of the delayed inverted first clock signal indicate the instants at which new data appearing at the second inputs (12) is already valid and data present at the first inputs (11) is still valid.

4. A circuit arrangement as claimed in Claim 3, characterized in that the control circuit (3) comprises a first phase comparator (34) for performing a phase comparison between the clock signal supplied by the first delay member and the second clock signal, as well as a second phase comparator (35) for performing a phase comparison between the signal supplied by the second delay member and the second clock signal, the output signals of the two phase comparators (34, 35) being applied to inputs of a first (36) and a second (37) pulse generator, the output signals of the two pulse generators (36, 37) being used to switch over the multiplexers (11) in the multiplexer arrangement (2).

5. A circuit arrangement as claimed in Claim 4, characterized in that the control circuit (3) is arranged for switching over between the two multiplexer inputs (11, 12) of the multiplexers (10) provided in the multiplexer arrangements (2), in dependence on the output signals of the two pulse generators (36, 37), in such a manner that switching over to the first multiplexer inputs takes place when the first phase comparator (34) supplies an output signal which indicates that the corresponding edges of the delayed first clock signal and the second clock signal overlap, and that switching over to the second multiplexer inputs (12) takes place when the second phase comparator (35) supplies an output signal which indicates that the corresponding edges of the delayed inverted first clock signal and the second clock signal overlap.

6. A circuit arrangement as claimed in any one of the Claims 1 to 5, characterized in that the digital signal is a digital television signal.

7. A circuit arrangement as claimed in Claim 6, characterized in that the circuit arrangement for conversion of a digital signal of a first clock frequency into a signal of a second clock frequency is succeeded by an image signal processing circuit, in which a digital image signal is processed at a system clock frequency which is not coupled to the image signal, which image signal processing circuit comprises a correction memory and an interpolator with a decimator which serve to convert the digital image signal to a synchronizing signal raster imposed by the system clock frequency, the circuit arrangement for conversion of the digital signal being used to convert the image signal supplied by the image signal processing circuit at the system clock frequency to a different clock frequency.

## Revendications

1. Montage de circuit pour la conversion d'un signal numérique présent à une première cadence, à une deuxième cadence, à l'aide d'un interpolateur/décimateur, qui comporte un nombre prédéterminé de registres d'entrée (5, 6, 7) cadencés à une cadence de registre et connectés en série, dont les signaux de sortie sont multipliés chaque fois dans un multiplicateur (21), par des coefficients de filtrage et sont ensuite additionnés, caractérisé en ce qu'au moins un dispositif de multiplexage (2) est prévu, qui est connecté en aval de l'un des registres d'entrée (5, 6, 7) connectés en série et en amont de l'un des multiplicateurs, et qui comporte un premier registre (9) cadencé à la première cadence inversée et un deuxième registre (14) cadencé à la deuxième cadence ainsi qu'un multiplexeur (10), en ce que le signal d'entrée du dispositif de multiplexage est acheminé au premier registre (9) et à une première entrée (11) du multiplexeur (10), dont la deuxième entrée (12) est couplée à la sortie du premier registre (9), et en ce qu'il est prévu une commande (3), qui commute les signaux acheminés aux deux entrées (11, 12) du multiplexeur (10) en alternance à sa sortie, de telle sorte qu'un signal valide soit toujours présent sur celui-ci aux instants où ce signal est introduit dans le deuxième registre (14).

2. Montage de circuit selon la revendication 1, caractérisé en ce que, dans l'interpolateur/décimateur (1), on connecte en aval de chacun des registres d'entrée connectés en série (5, 6, 7), un dispositif de multiplexage (2), dont les signaux de sortie sont acheminés au multiplicateur (21) chaque fois associé, en ce que la première cadence est utilisée comme signal de cadence de registre et en ce qu'une commande commune (3) est prévue pour les dispositifs de multiplexage (2).

3. Montage de circuit selon la revendication 1 ou 2, caractérisé en ce qu'il est prévu de disposer dans la commande (3) un premier élément à retard (32) et un deuxième élément à retard (33) qui retardent respectivement le premier signal de cadence et le premier signal de cadence inversé de valeurs de temps telles que les flancs du premier signal de cadence retardé indiquent les instants où de nouvelles données apparaissant aux premières entrées (11) des multiplicateurs (10) sont déjà valides et où des données présentes aux deuxièmes entrées (12) sont encore valides, et en ce que les flancs du premier signal de cadence inversé retardé indiquent les instants où de nouvelles données apparaissant aux deuxièmes entrées (12) sont déjà valides et des données présentes aux premières entrées (11) sont encore valides.

4. Montage de circuit selon la revendication 3, caractérisé en ce que dans la commande (3) sont prévus un premier comparateur de phase (34), qui effectue une comparaison de phase entre le signal de cadence délivré par le premier élément à retard et le deuxième signal de cadence, et un deuxième comparateur de phase (35), qui effectue une comparaison de phase entre le signal délivré par le deuxième élément à retard et le deuxième signal de cadence, en ce que les signaux de sortie des deux comparateurs de phase (34, 35) sont acheminés respectivement à un premier générateur d'impulsions (36) et à un deuxième (37) générateur d'impulsions, et en ce que les signaux de sortie des deux générateurs d'impulsions (36, 37) sont mis à profit pour renverser les multiplexeurs (11) dans les dispositifs de multiplexage (2).

5. Montage de circuit selon la revendication 4, caractérisé en ce que la commande (3) effectue, en fonction des signaux de sortie des deux générateurs d'impulsions (36, 37), un renversement entre les deux entrées (11, 12) des multiplexeurs (10) disposés dans les dispositifs de multiplexage (2), en renversant sur les premières entrées des multiplexeurs lorsque le premier comparateur de phase (34) délivre un signal de sortie qui indique que les flancs correspondants du premier signal de cadence retardé et du deuxième signal de cadence se superposent, et en renversant sur les deuxièmes entrées (12) des multiplexeurs lorsque le deuxième comparateur de phase (35) délivre un signal de sortie qui indique que les flancs correspondants du premier signal de cadence inversé retardé et du deuxième signal de cadence se superposent.

6. Montage de circuit selon l'une quelconque des revendications 1 à 5, caractérisé en ce que le signal numérique est un signal de télévision numérique.

7. Montage de circuit selon la revendication 6, caractérisé en ce que le montage de circuit de conversion d'un signal numérique présent à une première cadence, à une deuxième cadence, est connecté en aval d'un circuit de traitement de signaux vidéo, dans lequel un signal vidéo numérique est traité à une cadence de système, la cadence étant non associée au signal vidéo, et dans lequel sont montés une mémoire de correction et un interpolateur/décimateur, qui servent à la conversion du signal vidéo numérique sur un canevas de signaux synchrones prédéterminé par la cadence du système, et en ce que le montage de circuit de conversion du signal numérique est mis à profit pour convertir à une autre cadence le signal vidéo délivré à la cadence du système par le circuit de traitement de signaux vidéo.

# FIG.1

FIG.2

EP 0 491 422 B1